Europäisches Patentamt

European Patent Office

Office européen des brevets

(19)

(11) Veröffentlichungsnummer : **0 024 311**
B1

(12) **EUROPÄISCHE PATENTSCHRIFT**

(45) Veröffentlichungstag der Patentschrift :
**18.06.86**

(21) Anmeldenummer : **80104358.9**

(22) Anmeldetag : **24.07.80**

(51) Int. Cl.⁴ : **H 01 L 21/82, G 11 C 17/00,
H 01 L 27/10, H 01 L 29/08**

(54) **Verfahren zum Herstellen eines hochintegrierten Festwertspeichers.**

(30) Priorität : 20.08.79 US 68282

(43) Veröffentlichungstag der Anmeldung :
04.03.81 Patentblatt 81/09

(45) Bekanntmachung des Hinweises auf die Patenterteilung : 18.06.86 Patentblatt 86/25

(84) Benannte Vertragsstaaten :
AT DE FR GB NL SE

(56) Entgegenhaltungen :
US-A- 4 045 811
THE TRANSACTIONS OF THE IECE OF JAPAN, Band
E61, Nr. 7, Juli 1978, TOKYO (JP), K. SHIMOTORI u.a.:
"Dynamic DSA MOS RAM", Seiten 571-572.
ELECTRONICS, Band 51, Nr. 11, Mai 1978, NEW
YORK (US), "ROM-program-process may beat
EPROMs in turnaround time", Seiten 39-40

(73) Patentinhaber : International Business Machines Corporation
Old Orchard Road
Armonk, N.Y. 10504 (US)

(72) Erfinder : Fortino, Andreas Guillermo
Box A
Bryn Mawr Pennsylvania 19010 (US)
Erfinder : Geipel, Henry John jr.
1 Alderbrook Road
Essex Junction Vermont 05452 (US)
Erfinder : Heller, Lawrence Griffith
P. O. Box 341
Essex Vermont 05451 (US)
Erfinder : Silverman, Ronald
11 Rustic Drive
Essex Junction Vermont 05452 (US)

(74) Vertreter : Rudolph, Wolfgang, Dipl.-Ing.
Schönaicher Strasse 220
D-7030 Böblingen (DE)

**Beschreibung**

Die Erfindung betrifft ein Verfahren zum Herstellen eines hochintegrierten Speichers aus MOS-Feldeffekttransistoren, die in Kreuzungspunkten von Wort- und Bitleitungen liegen, und die verschiedene Schwellwertspannungen zur Darstellung der gespeicherten Zustände aufweisen, in dem die Programmierung erst in den letzten Prozeßschritten durch Borionenimplantation erfolgt. Ein derartiges Verfahren ist bereits aus ELECTRONICS, 25. Mai 1978, Band 51, Seiten 39-40, bekannt. Bei diesem bekannte Verfahren wird zur Ausbildung von P$^+$-Regionen zwischen Quelle- und Senke-Region während der beiden letzten Verfahrensschritte eine Maske aufgebracht und durch die Gate-Elektrode hindurch Bor implantiert.

Der Erfindung liegt die Aufgabe zugrunde, ein verbessertes Herstellungsverfahren für einen Festwertspeicher mit Feldeffekttransistoren, anzugeben um zu einer höheren Integrationsdichte zu gelangen.

Die Erfindung wird nun anhand von in der Zeichnung dargestellten Ausführungsbeispielen näher erklärt.

In der Zeichnung bedeuten :

Figur 1 eine Draufsicht auf einen Ausschnitt aus einem nach dem vorliegenden Herstellungsverfahren hergestellten Festwertspeicher ;

Figur 2 eine Schnittansicht des Gegenstands der Fig. 1 ;

Figur 3 eine weitere Schnittansicht des Gegenstands der Fig. 1 ;

Figur 4 eine Schnittansicht des Gegenstands der Fig. 1 vor der Personalisierung und

Figur 5 eine Schnittansicht des Gegenstands der Fig. 5 unmittelbar nach der Personalisierung.

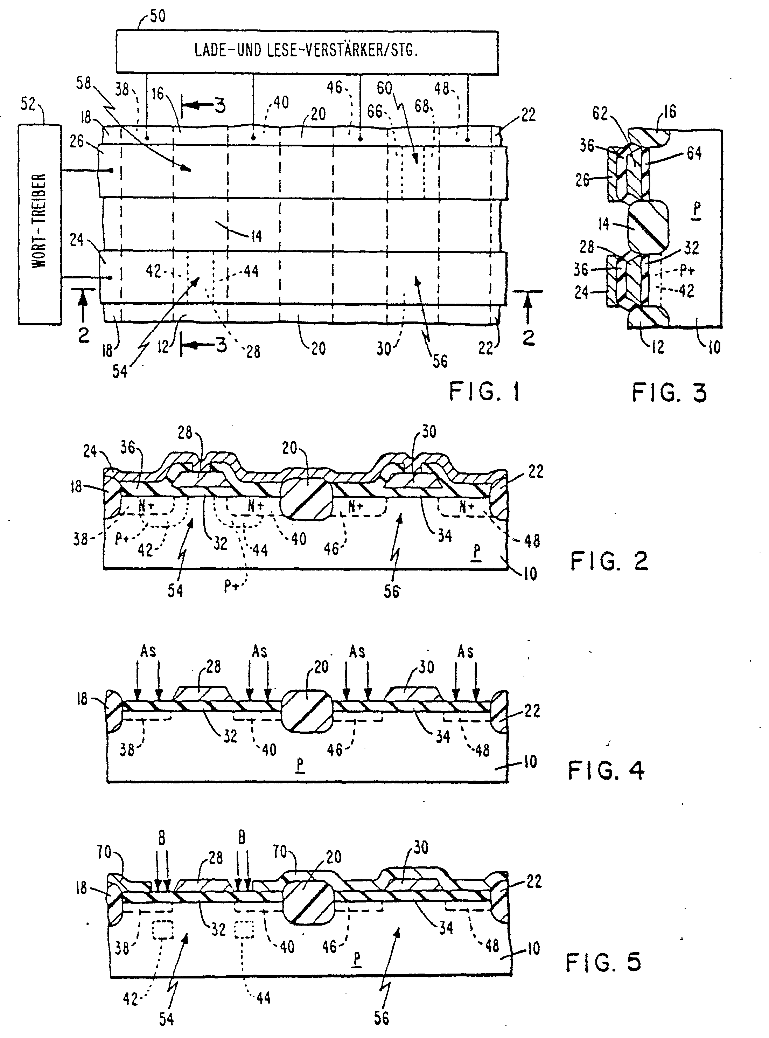

In den Fign. 1 bis 3 ist ein teilweise dargestellter Festwertspeicher zu sehen, der mit dem Herstellungsverfahren der vorliegenden Erfindung hergestellt worden ist.

Dieser Festwertspeicher besteht aus einem Substrat 10 vom P-leitenden Typ, in das tiefer liegende Oxidsegmente 12, 14 und 16 eingebracht sind, wie insbesondere aus Fig. 3 klar zu ersehen ist. Außerdem sind noch Oxidstreifen 18, 20 und 22 in das Substrat 10 eingebracht, wie deutlich aus Fig. 2 zu ersehen ist. Zwischen den tiefer liegenden Oxidsegmenten 12 und 14 ist eine erste Wortleitung 24 angeordnet, wie klar aus Fig. 3 zu ersehen ist, und zwischen den tiefer liegenden Oxidstreifen 14 und 16 ist eine zweite Wortleitung 26 angeordnet, wie klar aus Fig. 3 zu ersehen ist. Die erste und die zweite Wortleitung 24 und 26 können z. B. aus Aluminium oder einem entsprechenden Leiter hergestellt sein. Die erste Wortleitung 24 ist mit einer Gateelektrode 28 verbunden, die durch eine dünne dielektrische Schicht 32 vom Substrat 10 getrennt ist. Diese dünne dielektrische Schicht 32 wird vorzugsweise aus Siliciumdioxid hergestellt, außerdem ist sie mit einer Gateelektrode 30 verbunden, die ebenfalls durch eine dünne dielektrische Schicht 34 vom Substrat 10 getrennt ist. Aus den Figuren ist klar zu ersehen, daß die Wortleitungen 24 mit den Gateelektroden über den Kanalregionen verbunden ist, wobei jedoch zu beachten ist, daß die Kontakte in der Praxis genausogut auch über den Isolationsregionen hergestellt werden können. Die erste und die zweite Wortleitung 24 und 26 sind durch eine dicke Isolationsschicht 36 vom Substrat 10 getrennt.

Eine erste N$^+$-Diffusionregion 38 ist im Substrat 10 zwischen der Gateelektrode 28 und dem tiefer liegenden Oxidstreifen 18 gebildet, und eine zweite N$^+$-Diffusion 40 ist im Substrat 10 zwischen der Gateelektrode 28 und dem tiefer liegenden Oxidstreifen 20 gebildet, wie klar aus Fig. 2 hervorgeht. Außerdem ist eine hofartige P$^+$-Region 42 im Substrat 10 gebildet und zwar angrenzend an die erste N$^+$-Region 38 und zwischen dieser und der zweiten N$^+$-Region 40. Eine zweite P$^+$-Region 44 ist unmittelbar an der zweiten N$^+$-Region 40 und zwischen der ersten und zweiten N$^+$-Region 38 und 40 zu sehen. Eine dritte N$^+$-Region 46 wird im Substrat 10 zwischen der Gateelektrode 30 und dem tief liegenden Oxidstreifen 20 gebildet und eine vierte N$^+$-Diffusionregion 48 wird zwischen der Gateelektrode 30 und dem tiefer liegenden Oxidstreifen 22 gebildet. Die erste bis vierte N$^+$-Diffusionsregionen 38, 40, 46 und 48 sind mit den Lade- und Leseverstärker-Steuerungsschaltungen 50 verbunden, und die ersten und zweiten Wortleitungen 24 und 26 sind mit den Wortleitungstreibern 52 verbunden. Die Schaltungen können als beliebig bekannte Schaltungen ausgeführt sein, die die Bedingungen für den vorliegenden Speicher erfüllen.

Der in den Fign. 1 bis 3 gezeigte Festwertspeicher hat vier Zellen 54, 56, 58 und 60, wobei die Zellen 54 und 56 mit der ersten Wortleitung 24 und die Zellen 58 und 60 mit der zweiten Wortleitung 26 verbunden sind, wie aus der Fig. 2 zu ersehen ist. Die erste Zelle 54 wird durch einen Transistor gebildet, der aus der Gateelektrode 28 und den N$^+$-Quellen- und Senkenregionen 38 bzw. 40 sowie aus den ersten und zweiten P$^+$-Regionen 42 und 44 besteht. Die zweite Zelle 56 wird durch die Gateelektrode 30 und die dritte und vierte N$^+$-Source- und Drainregion 46 und 48 gebildet. Die dritte Zelle 58 ist mit der zweiten Wortleitung 26 verbunden und besteht aus der Gateelektrode 62, siehe Fig. 3, die vom Substrat 10 durch eine dünne dielektrische Schicht 64 getrennt ist und aus den ersten und zweiten N$^+$-Source- und Drainregionen 38 und 40. Die vierte Zelle 60, die ebenfalls mit der Wortleitung 26 verbunden ist, besteht aus der Gateelektrode (nicht zu sehen) und den dritten und vierten N$^+$-Source- und Drainregionen 46 und 48 sowie den dritten und vierten P$^+$-Regionen 66 und 68.

Das erfindungsgemäße Herstellungsverfahren für einen Speicher, wie er in den Fign. 1 bis 3 dargestellt ist, wird nun anhand der Fign. 4 und 5 detailliert erklärt.

Mit Hilfe einer bekannten Technik werden die vertieften Oxidstreifen 18, 20 und 22 sowie die vertieften Oxidsegmente 12, 14 und 16 im Substrat 10 gebildet. Nachdem die vertieften Oxidsegmente und -streifen gebildet sind, wird eine dünne Schicht Siliciumdioxid auf die Oberfläche des Substrats 10, wie bei 32 und 34 in den Fign. 4 und 5 gezeigt, aufgebracht. Danach wird der Schwellwert aller Transistoren oder Zellen auf einen gegebenen Grundpegel gebracht, indem typische Anreicherungsimplantanate an diesem Punkt in das Substrat 10 eingebracht werden. Nach der Formation der Siliciumdioxidschicht 32, 34 und der Implantation wird eine Schicht elektrisch leitenden Materials, wie z. B. Polysilicium, auf die Siliciumdioxidschicht 32, 34 aufgebracht, und die Gateelektroden 28 und 30 werden mit Hilfe der bekannten Masken und Ätztechniken von der ersten Polysiliciumschicht gebildet.

Dann wird durch Ionenimplantation Arsen in das Substrat 10 eingebracht (siehe Fig. 4), um $N^+$-Regionen 38, 40 und 46 sowie 48 zu schaffen, die zusammen mit den Gateelektroden, wie z. B. 28 und 30, den vertieften Oxidstreifen 18, 20 und 22 und den vertieften Oxidsegmenten 12, 14 und 16 das erforderliche Muster bilden. Zu diesem Zeitpunkt des Herstellungsprozesses hat nun jeder Transistor innerhalb der Matrix eine Gateelektrode, eine Quellenelektrode und eine Senkenelektrode. Das bis zu diesem Prozeßschritt hergestellte Bauteil kann nun so lange gelagert werden, bis Klarheit über die eigentliche Anwendung des so hergestellten Festwertspeichers erzielt ist, und die Personalisierung kann somit ohne Probleme am Ende des gesamten Herstellungsprozesses vorgenommen werden. Insbesondere dieser Vorteil ist bei Festwertspeichern mit einer hohen Integrationsdichte bisher nicht erzielt worden.

Wenn die Informationen für eine Personalisierung eines bis zu diesem Schritt hergestellten Festwertspeichers vorliegen, kann eine entsprechende Maske, wie z. B. eine Photolackmaske, wie sie als Schicht 70 in Fig. 5 dargestellt ist, hergestellt werden. Diese Schicht bedeckt alle Zellen oder Transistoren, die eine niedrige Schwellwertspannung aufweisen sollen, wie z. B. im vorliegenden Falle die Zellen 56 und 58, während dem andererseits die Photomaske 70 Öffnungen aufweisen soll, für die Transistoren, die eine hohe Schwellwertspannung haben sollen, wie z. B. im vorliegenden Falle die Zelle 54. Die Ausrichtung und Übereinstimmung der Maske 70 ist hier nicht kritisch, jedoch sollten die Ecken der Maske 70, um Streukapazitäten zu verringern, mit der $N^+$-Quellen- und Senkenregion 38 und 40, wie in Fig. 5 dargestellt, zusammenfallen. Durch Ionenimplantation wird dann Bor, in Fig. 5 als $B^+$ gekennzeichnet, in das Substrat 10 mit der Photomaske 70 eingebracht, und die Gateelektroden, wie z. B. die Gateelektrode 28, definiert die $P^+$-Regionen 42 und 44, die erforderlich sind, um eine hohe Schwellwertspannung in der Zelle 54 zu schaffen. Nachdem das Bor in das Substrat 10 eingebracht wurde, wird die Photolackmaske 70 entfernt, und die Polysilicon-Gateelektroden und die Quellen- und Senken-Regionen werden oxidiert, um die dicke Isolationsschicht 36 zu bilden. Wegen der größeren Diffusion von Bor im Vergleich zum Arsen wird beim Erwärmen des Substrats, z. B. während eines Oxidationsschrittes, auf ungefähr 1000° für ca. 100 Minuten das Bor wesentlich schneller in das Substrat 10 eindringen als das Arsen, um die $P^+$-Regionen 42 und 44 in ihrer Endposition unter der Gateelektrode 28 zwischen der $N^+$-Quellen- und Senken-Region 38 und 40 zu bestimmen. Wie in Fig. 1 dargestellt ist, hat die Zelle 60, die $P^+$-Regionen 66 und 68 aufweist, eine hohe Schwellwertspannung. Sie ist in der gleichen Art und Weise wie die Zelle 54 gebildet worden. Die Differenz zwischen der niederen und der höheren Schwellwertspannung kann bei 4 Volt liegen. Die Wortleitungen 24 und 26, welche aus Aluminium oder eine zweiten Polysiliconschicht bestehen können, werden über der dicken Isolationsschicht 36 in bekannter Art und Weise gebildet und mit den Gateelektroden verbunden.

Da die Transistoren einer Speicherzelle entweder eine hohe oder eine niedrige Schwellwertspannung aufweisen, hat der Wortimpuls, der auf die Wortleitung gegeben wird, eine Größe zwischen der hohen und der niedrigen Schwellwertspannung. Vor der Beaufschlagung einer selektierten Wortleitung mit einem Wortimpuls werden die Bitleitungen, die hier z. B. als $N^+$-Diffusionsregionen 38 und 46 ausgebildet sind, auf ein gegebenes Potential vorgeladen, und die Leitungen, die durch die $N^+$-Diffusionsregionen 40 und 48 gebildet werden, werden mit Masse verbunden. Während der Wortimpuls auf die erste Wortleitung 24 gegeben wird, nimmt die Spannung auf der Bitleitung 38 entsprechend der hohen Schwellwertspannung der Zelle 54 einen Wert an, wodurch die Spannung auf der Bitleitung 48 nach Masse entladen wird, gemäß der niederen Schwellwertspannung der Zelle 56. Die Bitleitungspotentiale können dann unmittelbar auf bekannte Art und Weise abgefühlt und erkannt werden. Daraus ist zu sehen, daß bei Selektierung der Wortleitung 26 die Spannung auf der Bitleitung 38 nach Masse absinkt und die Spannung auf der Bitleitung 46 hoch bleibt.

Obwohl im Interesse der Klarheit der Erklärung und der Darstellung nur zwei Zellen in den vorliegenden Beispielen dargestellt sind, ist die Erfindung selbstverständlich bei einer wesentlich größeren Anzahl von Zellen ebenfalls praktikabel. Es ist selbstverständlich auch möglich, wenn es gewünscht wird, daß die Zellen mit der hohen Schwellwertspannung asymmetrisch gefertigt werden können und zwar lediglich dadurch, daß nur eine $P^+$-Region unter die Gateelektrode, z. B. der Zelle 54, angeordnet wird, und daß dann nur eine der beiden $P^+$-Regionen 42 und 44 erforderlich ist. Außerdem kann die Zellendichte innerhalb des Speichers noch dadurch erhöht werden, daß die $N^+$-Diffusionsregionen so angeordnet werden, daß eine Diffusionsregion durch zwei oder mehrere Zellen in einer gegebenen Wortleitung benutzt wird.

Im vorliegenden ist ein Festwertspeicher beschrieben worden, der zur Speicherung von binären Informationen geeignet ist. Es soll nun noch gezeigt werden, daß es mit Hilfe des Herstellungsverfahrens auch möglich ist, jede Zelle so aufzubauen, daß sie mehrere Zustände einnehmen kann, d. h., daß somit Speicher aufgebaut werden können, die · eine Mehrzustandsspeicherung in einer Zelle ermöglichen. Dies geschieht z. B. durch Anwendung der bekannten Technik, nach der in die Kanalregion eines Transistors eine verschieden große Quantität von Bor eingebracht wird. Z. B. können vier Zellen so ausgeführt sein, daß jede Zelle eine verschiedene Schwellwertspannung besitzt, indem erstens eine bestimmte Dosis von Bor in zwei Zellen eingebracht wird und zweitens eine zweite Dosis von Bor in eine der vorhergehenden implantierten Zellen und in eine der hier nicht implantierten Zellen.

Wenn eine derartige Mehrzustandsspeicherung verwendet wird, müssen auch entsprechende bekannte Abfühl- und Leseverstärker mit den entsprechenden Bitleitung verbunden werden, die z. B. vier verschiedene Zustände der Schwellwertspannungen erkennen können.

Das für die $N^+$-Regionen 38, 40, 46 und 48 verwendete Arsen wird vorzugsweise ein Material mit einer Konzentration von $8 \times 10^{15}$ Ionen/cm² sein, welches bei 80 KeV eingebracht wird, und die Bor-Dosis, die zu Schaffung der $P^+$-Regionen 42, 44, 66 und 68 erforderlich ist, wird mit einer Konzentration von 1 bis $10 \times 10^{13}$ Ionen/cm² bei 100 bis 200 KeV implantiert. Der Vollständigkeit halber soll hier noch erwähnt sein, daß es jedoch auch ohne weiteres möglich ist, Transistoren vom Verarmungstyp herzustellen und nicht nur wie beschrieben Transistoren vom Anreicherungstyp.

Mit dem vorliegenden ist ein Herstellungsprozeß für einen Festwertspeicher beschrieben worden, der es ermöglicht, daß der Festwertspeicher vor der eigentlichen Personalisierung bereits mindestens zu 80 % fertig ist.

**Patentanspruch**

Verfahren zur Herstellung eines Festwertspeichers aus MOS-Feldeffekttransistoren, die in Kreuzungspunkten von Wort- und Bitleitungen liegen, und die verschiedene Schwellwertspannungen zur Darstellung der gespeicherten Zustände aufweisen, in dem die Programmierung erst in den letzten Prozeßschritten durch Borionenimplantation erfolgt, dadurch gekennzeichnet, daß in ein Halbleitersubstrat (10) welches Gateelektroden (28, 30), vertiefte Oxidstreifen (18, 20, 22) und vertiefte Oxidsegmente (12, 14, 16) aufweist, durch Ionenimplantation Arsen eingebracht wird, um $N^+$ Quellen- bzw. Senken-Regionen (38, 40, 46, 48) zu bilden, die zusammen mit den Gateelektroden, den vertieften Oxidstreifen und den vertieften Oxidsegmenten (Speicherzellen) bilden, daß zur Programmierung eine entsprechende Maske (70) alle Speicherzellen (56 und 58) bedeckt die eine niedrige Schwellwertspannung aufweisen sollen, während dem sie für die Speicherzellen (54), die eine hohe Schwellwertspannung aufweisen sollen, Öffnungen aufweist, durch die die Ionenimplantation mit Borionen erfolgt, wobei die Gateelektroden (28) ebenfalls als Maske wirken, und aß danach eine Eindiffusion der implantierten Arsen- und Borionen mit unterschiedlicher Geschwindigkeit erfolgt, wodurch $P^+$ Regionen (42 und 44) in ihrer Endposition unter der Gateelektrode (28) zwischen der $N^+$-Quellen- und $N^+$-Senken-Region (38 und 40) erzeugt werden.

**Claim**

Method of making a read only memory of MOS field effect transistors provided in points of word and bit line intersections and comprising different threshold voltages to represent the states stored, where programming is effected by boron ion implantation in the last process steps only, characterized in that into a semiconductor substrate (10) comprising gate electrodes (28, 30), recessed oxide strips (18, 20, 22) and recessed oxide segments (12, 14, 16) arsenic is introduced through ion implantation in order to form $N^+$ source and drain regions (38, 40, 46, 48) which together with the gate electrodes, the recessed oxide strips and the recessed oxide segments form storage cells, that for programming a corresponding mask (70) covers all memory cells (56 and 58) which are to have a lower threshold voltage, whereas for the memory cells (54) which are to have a high threshold voltage it comprises openings through which ion implantation with boron ions is effected, with the gate electrodes (28) also serving as a mask, and that subsequently the implanted arsenic and boron ions are diffused with different speed, after which $P^+$ regions (42 and 44) are generated in their end position under the gate electrode (28) between the $N^+$ source and $N^+$ drain regions (38 and 40).

**Revendication**

Procédé pour fabriquer une mémoire morte constituée par des transistors à effet de champ MOS, qui sont situés au niveau de points d'intersection de lignes de transmission de mots et de lignes de transmission de bits, et qui possèdent des tensions de seuil différentes pour représenter les états mémorisés, et selon lequel la programmation s'effectue uniquement pendant les dernières phases opératoires par implantation d'ions de bore, caractérisé en ce que dans un substrat semiconducteur (10), qui comporte des électrodes de grille (28, 30), des bandes d'oxyde en renfoncement (18, 20, 22) et des segments d'oxyde en renfoncement (12, 14, 16), on introduit de l'arsenic par implantation ionique de manière à former des régions de source et des régions de drain de type $N^+$ (38, 40, 46, 48), qui forment, en association avec les électrodes de grille, les bandes d'oxyde en renfoncement et les segments d'oxyde en renfoncement, des cellules de mémoire, que, pour la programmation, un masque correspondant (70) recouvre toutes les cellules de mémoire (56, 58) qui doivent posséder une tension de seuil faible, tandis que ce masque comporte, pour les cellules de mémoire (54) qui doivent posséder une tension de seuil élevée, des ouvertures à travers lesquelles l'implantation ionique à l'aide d'ions de bore est réalisée, auquel cas les électrodes de grille (28) agissent également à la manière d'un masque, et qu'ensuite il se produit une diffusion des ions d'arsenic et de bore implantés, à des vitesses différentes, ce qui permet de réaliser des régions de type $P^+$ (42 et 44) dans leur position finale au-dessous de l'électrode de grille (28) entre la région de source de type $N^+$ et la région de drain de type $N^+$ (38 et 40).

0 024 311

FIG. 1

FIG. 3

FIG. 2

FIG. 4

FIG. 5